(19) **Europäisches Patentamt**
**European Patent Office**
**Office européen des brevets**

(11) **EP 0 922 962 B2**

(12) **NEUE EUROPÄISCHE PATENTSCHRIFT**
Nach dem Einspruchsverfahren

(45) Veröffentlichungstag und Bekanntmachung des Hinweises auf die Entscheidung über den Einspruch:
**16.10.2013 Patentblatt 2013/42**

(45) Hinweis auf die Patenterteilung:
**08.10.2003 Patentblatt 2003/41**

(21) Anmeldenummer: **97121751.8**

(22) Anmeldetag: **10.12.1997**

(51) Int Cl.:
**G01R 19/25** (2006.01)    **G01R 27/26** (2006.01)

(54) **Verfahren und Vorrichtung zur zeitdiskreten Messung einer Reaktanz**

Procedure and device for sampling a reactance

Procédé et appareil d'échantillonnage d'une réactance

(84) Benannte Vertragsstaaten:
**DE FR GB IT**

(43) Veröffentlichungstag der Anmeldung:
**16.06.1999 Patentblatt 1999/24**

(73) Patentinhaber:
• **Endress + Hauser GmbH + Co. KG**
**79689 Maulburg (DE)**
• **Endress+Hauser (Deutschland) AG+Co. KG**
**79576 Weil am Rhein (DE)**

(72) Erfinder:
• **Schreiber, Ronald, Dipl.-Ing.**
**79539 Lörrach (DE)**
• **Lalla, Robert, Dr.**
**79541 Lörrach (DE)**

(74) Vertreter: **Andres, Angelika Maria et al
Endress+Hauser (Deutschland) AG+Co. KG
PatServe
Colmarer Strasse 6
79576 Weil am Rhein (DE)**

(56) Entgegenhaltungen:
EP-A- 0 421 953    EP-A1- 0 715 408
DE-A- 3 611 683    DE-A1- 3 544 187
DE-A1- 3 611 683    DE-A1- 19 701 899
US-A- 5 115 189    US-A- 5 699 005

• **MATSUMOTO ET AL.: "A SWITCHED CAPACITOR DIGITAL CAPACITANCE METER" IEEE TRANSACTIONS ON INSTRUMENTATION AND MEASUREMENT., Bd. IM-35, Nr. 44, Dezember 1986, NEW YORK US, Seiten 555-559, XP002063455**
• **Bd. 6 1995, SPRINGER-VERLAG, BERLIN vol. H.D. LÜKE: 'Signalübertragung, Grundlagen de digitalen und analogen nachrichtenübertragungssysteme'**
• **Bd. 10 1993, SPRINGER-VERLAG, HEIDELBERG vol. U.TIETZE, CH. SCHENK: 'Halbleiter-Schaltungstechnik'**
• **Bd. 7 1992, HÜTHIG BUCH VERLAG, HEIDELBERG vol. O.FÖLLINGER: 'Regelungstechnik, Einführung in die Methoden und ihre Anwendung'**
• **Bd. 5 1992, SPRINGER-VERLAG, BERLIN vol. K.LANGE, K. LÖCHERER: 'Taschenbuch der Hochfrequenztechnik, Grundlagen, Komponenten, Systeme'**

EP 0 922 962 B2

**Beschreibung**

Die Erfindung betrifft ein Verfahren zur zeitdiskreten Messung einer Reaktanz, bei welchem die Reaktanz durch eine taktgesteuerte Generatorvorrichtung mit einer elektrischen Spannung, einem elektrischen Strom oder einer elektrischen Ladung angeregt wird und eine taktgesteuerte Auswertevorrichtung ein Ausgangssignal als Funktion der zu messenden Reaktanz aus zeitdiskreten Abtastwerten der elektrischen Spannung, des elektrischen Stroms oder der elektrischen Ladung erzeugt, wobei die Generatorvorrichtung und die Auswertevorrichtung im gleichen Takt gesteuert werden.

Kapazitive und induktive Sensoren haben für die Messung einer Vielzahl physikalischer Größen eine weite Verbreitung gefunden. Solche Sensoren lassen sich in der Regel nicht statisch auswerten und müssen deshalb durch einen Generator mit einer Wechselspannung oder einem Wechselstrom angeregt werden. Für die Bestimmung der Sensorreaktanz gibt es verschiedene Möglichkeiten. Wegen der guten Integrierbarkeit wird häufig die SC- Technik ("Switched- Capacitor"- Technik) mit Schalter- Kondensator- Strukturen angewendet. Jeder Auswertezyklus besteht dabei aus einer oder mehreren Vorladephasen (Anregung) und aus einer oder mehreren Meßphasen (Auswertung). Die SC- Technik stellt somit ein zeitdiskretes Verfahren dar.

Die Messung von Kapazitäten nach der SC-Technik ist beispielsweise aus dem Aufsatz "A Switched-Capacitor Digital Capacitance Meter" von Hiroki Matsumoto und Kenzo Watanabe in der Zeitschrift "IEEE Transactions on Instrumentation and Measurement", Vol. IM-35, Nr. 4, Dezember 1986, S. 355-359, und aus der DE 35 44 187 A1 bekannt. Bei diesen bekannten Verfahren wird für die Anregung und für die Auswertung ein konstanter Takt angewendet, so daß die Zeitabstände zwischen den Auswertezeitpunkten stets gleich groß sind. Bekanntlich muß entsprechend dem Nyquist-Abtasttheorem die Wiederholfrequenz der Auswertung mindestens doppelt so hoch sein wie die höchste Frequenz der zu messenden Größe. Das Verhältnis der Auswertungs-Taktfrequenz zu dem doppelten Wert der höchsten Frequenz der zu messenden Größe bezeichnet man als Oversampling-Rate. Wenn dieses Verhältnis kleiner als 1 ist, wird das NyquistNyquist-Abtasttheorem verletzt und es kommt zu Aliasing-Fehlern.

In den meisten Anwendungen verlaufen die zeitlichen Änderungen der zu messenden Reaktanz verhältnismäßig langsam, so daß eine hohe Oversampling-Rate möglich ist und zur Verbesserung der Meßgenauigkeit auch oft angewendet wird. Auf die zu messende Reaktanz werden aber durch äußere Einflüsse auch störende Wechselsignale eingekoppelt. Die Frequenzen dieser Störungen können in Bereichen liegen, die zu einer Verletzung des Nyquist-Abtasttheorems führen. Durch Aliasing kommt es dann zu einer Abbildung des Störsignals auf das Nutzsignal und damit zu einer Verfälschung der Reaktanzmessung. Insbesondere ergeben sich in der näheren Umgebung von ganzzahligen Vielfachen der Auswertungs-Taktfrequenz (Abtastfrequenz) Bereiche mit hoher Störempfindlichkeit.

Es ist andrerseits bekannt, einen Systemtakt zur Verringerung von Störeinflüssen durch eine Frequenz- oder Phasenmodulation zu variieren. Hierfür sind in der EP 0 715 408 A1 verschiedene bekannte Lösungen aufgeführt, und es wird eine weitere Lösung angegeben, bei der ein Ursprungstakt mittels eines Phasenmodulatators in Abhängigkeit von einer Zufallssignalquelle moduliert wird. In der DE 196 37 942 A1 ist ein Verfahren zur Modulation des Erfassungstaktes eines digitalen Oszilloskops unter Verwendung einer Phasenverriegelungsschleife beschrieben.

Die Offenlegungsschrift DE 197021899 A1 offenbart eine Schaltungsanordnung zum Erfassen einer Kapazität, bei der die Kapazität mit einem frequenzmodulierten Anregetakt geladen wird, um eine geglättete Gleichspannung als Maß für die Kapazität an einer Speicherkapazität zu erzeugen.

Demgegenüber liegt der Erfindung die Aufgabe zugrunde, bei der zeitdiskreten taktgesteuerten Messung *von* Reaktanzen den durch Aliasing hervorgerufenen Einfluß schmalbandiger Störeinkopplungen zu verringern.

Ausgehend von dem eingangs angegebenen Verfahren wird diese Aufgabe nach der Erfindung gelöst durch die Merkmale des Anspruchs 1, wobei der die Generatorvorrichtung und die Auswertevorrichtung steuernde Takt in gleicher Weise durch eine Frequenz- oder Phasenmodulation variiert wird.

Das erfindungsgemäße Verfahren ergibt die Wirkung, daß im Vergleich zu den üblichen Meßverfahren mit konstantem Anregungs- und Auswertungtakt die Empfindlichkeit in der Nähe von Vielfachen der Abtastfrequenz geringer und auf einen größeren Frequenzbereich aufgeweitet ist. Eine Störung, die sich nicht über die gesamte Bandbreite eines empfindlichen Bereichs ausdehnt, hat damit auf die Messung einen geringeren Einfluß als bei einer Messung mit konstantem Takt.

Eine Vorrichtung zur Durchführung des erfindungsgemäßen Verfahrens enthält die Merkmale gemäß Anspruch 6.

Vorteilhafte Ausgestaltungen und Weiterbildungen des erfindungsgemäßen Verfahrens und der Vorrichtung zu dessen Durchführung sind in den Unteransprüchen gekennzeichnet.

Weitere Merkmale und Vorteile der Erfindung ergeben sich aus der folgenden Beschreibung von Ausführungsbeispielen an Hand der Zeichnungen. In den Zeichnungen zeigen:

Fig. 1          das Blockschema einer Vorrichtung zur zeitdiskreten Messung einer Reaktanz gemäß der Erfindung,

Fig. 2       das Schaltbild eines Ausführungsbeispiels der Vorrichtung von Fig. 1 in SC- Technik,

Fig. 3 bis 9       Diagramme zur Erläuterung der mit der Erfindung erzielten Wirkung,

Fig. 10       das Blockschema eines Oversampling- A/D- Wandlers, der in der Auswerteschaltung der Vorrichtung von Fig. 1 anwendbar ist,

Fig. 11       das Schaltbild eines Ausführungsbeispiels der Vorrichtung von Fig. 1 in SC- Technik mit einem Oversampling- A/D- Wandler gemäß Fig. 10,

Fig. 12       das Blockschema eines Dezimationsfilters, das bei variablem Eingangstakt ein Ausgangssignal mit konstantem Ausgangstakt liefert, und

Fig. 13       das Blockschema eines mit einer Steuervorrichtung kombinierten Taktgenerators, der einen digital modulierten Takt liefert.

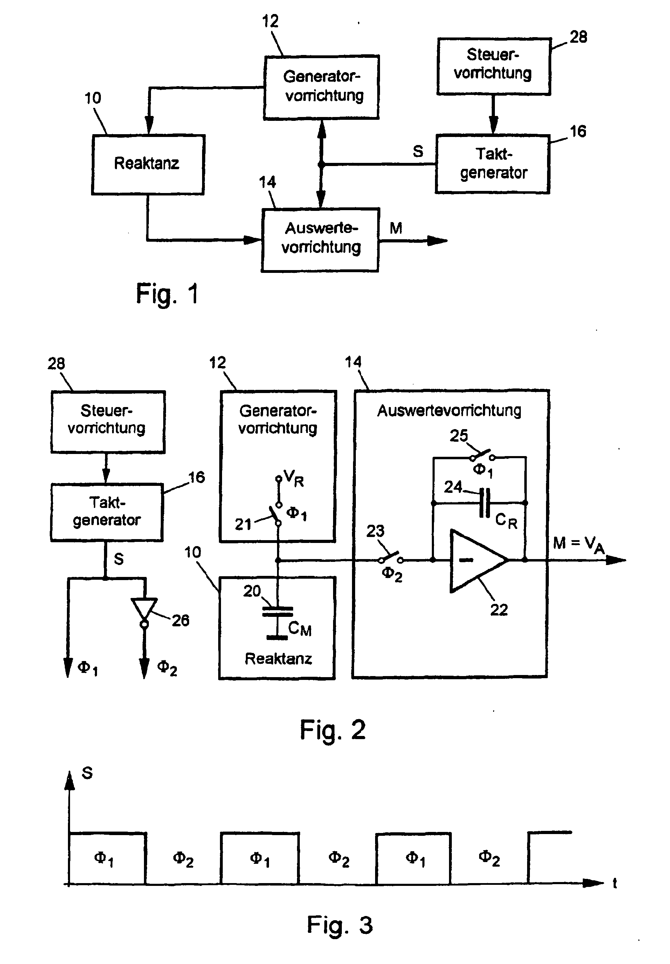

Fig. 1 zeigt das Blockschema einer Anordnung zur taktgesteuerten Messung einer Reaktanz. Die zu messende Reaktanz, die beispielsweise ein kapazitiver oder induktiver Sensor zur Erfassung einer physikalischen Größe sein kann, ist durch den Schaltungsblock 10 dargestellt. Solche Sensoren lassen sich in der Regel nicht statisch auswerten und müssen deshalb durch eine Generatorvorrichtung 12 mit einer Wechselspannung, einem Wechselstrom oder mit elektrischen Ladungen angeregt werden. Eine Auswertevorrichtung 14 erzeugt auf Grund der durch die Reaktanz 10 beeinflußten Größe der Wechselspannung, des Wechselstroms bzw. der elektrischen Ladungen ein Ausgangssignal, das die Größe der zu messenden Reaktanz anzeigt.

Für die Bestimmung der Reaktanz gibt es verschiedene Möglichkeiten. Wegen der guten Integrierbarkeit wird häufig die "Switched- Capacitor- Technik"- Technik" (SC- Technik) angewendet, die nach dem Prinzip des quantisierten Ladungstransports mit Schalter- Kondensator- Strukturen arbeitet. Jeder Auswertezyklus besteht dabei aus einer oder mehreren taktgesteuerten Vorladephasen zur Anregung und einer oder mehreren taktgesteuerten Meßphasen zur Auswertung. Die SC- Technik stellt somit ein zeitdiskretes Verfahren dar. Die Anordnung von Fig. 1 enthält daher einen Taktsignalgenerator 16, der ein Taktsignal S zur Generatorvorrichtung 12 und zur Auswertevorrichtung 14 liefert. Das Taktsignal S bestimmt den Takt der Anregung durch die Generatorvorrichtung 12 und den Takt der Auswertung durch die Auswertevorrichtung 14. Durch die Auswerteschaltung 14 wird ein Ausgangssignal M als Funktion der zu messenden Reaktanz erzeugt. In den üblichen SC- Schaltungen sind Generatorvorrichtung und Auswertevorrichtung kombiniert.

Fig. 2 zeigt als Beispiel das Grundprinzip einer Anordnung zur Messung der Kapazität $C_M$ eines kapazitiven Sensors 20 nach der SC-Technik. Der kapazitive Sensor 20 ist symbolisch als Kondensator dargestellt. Die Generatorvorrichtung 12 enthält einen Schalter 21, der im geschlossenen Zustand eine Referenzspannung $V_R$ an die Kapazität $C_M$ anlegt und im geöffneten Zustand die Verbindung zwischen der Kapazität $C_M$ und der Referenzspannung $V_R$ unterbricht. Die Auswertevorrichtung 14 enthält einen Verstärker 22 mit hoher negativer Verstärkung und einen Schalter 23, der im geschlossenen Zustand den Verbindungspunkt zwischen der Kapazität $C_M$ und dem Schalter 21 mit dem Eingang des Verstärkers 22 verbindet. Im Rückkopplungskreis des Verstärkers 22 liegt ein Referenzkondensator 24 mit der Kapazität $C_R$, dem ein Schalter 25 parallelgeschaltet ist. Wenn der Schalter 25 geöffnet ist, bildet der Verstärker 22 zusammen mit dem Referenzkondensator 24 einen Integrator. Wenn der Schalter 25 geschlossen ist, entlädt sich der Referenzkondensator 24, wodurch der Integrator auf Null zurückgestellt wird.

Das vom Taktsignalgenerator 16 erzeugte Taktsignal S ist ein Rechtecksignal der Frequenz $\omega_S = 2\pi f_S$, das in dem Zeitdiagramm von Fig. 3 dargestellt ist. Das Taktsignal S hat abwechselnde Phasen $\Phi_1$, in denen es den hohen Signalwert hat, und $\Phi_2$, in denen es den niedrigen Signalwert hat. Die Schalter 21 und 25 werden durch das Taktsignal S so gesteuert, daß sie in den Phasen $\Phi_1$ geschlossen und in den Phasen $\Phi_2$ offen sind. Dagegen wird der Schalter 23 so gesteuert, daß er in den Phasen $\Phi_1$ offen und in den Phasen $\Phi_2$ geschlossen ist. Wenn alle Schalter so ausgebildet sind, daß sie beim hohen Signalwert des sie steuernden Signals geschlossen und beim niedrigen Signalwert offen sind, kann die gegensinnige Steuerung auf einfache Weise dadurch erreicht werden, daß das Taktsignal S an die Schalter 21 und 25 direkt und an den Schalter 23 über einen Inverter 26 angelegt wird. In Fig. 2 sind der besseren Übersichtlichkeit wegen die Verbindungen zwischen den Ausgängen des Taktsignalgenerators 16 bzw. des Inverters 26 und den Schaltern 21, 23, 25 nicht dargestellt, sondern es ist bei jedem Schalter angegeben, durch welche Phase des Taktsignals S er gesteuert wird. Somit wird in jeder Phase $\Phi_1$ des Taktsignals S die zu messende Kapazität $C_M$ des kapazitiven Sensors 20 auf die Referenzspannung $V_R$ aufgeladen und die Kapazität $C_R$ des Referenzkondensators 24 entladen, und in jeder Phase $\Phi_2$ des Taktsignals S entlädt sich die Kapazität $C_M$ in die Referenzkapazität $C_R$. Am Ausgang des Verstärkers stellt sich daher in der Phase $\Phi_2$ als Meßsignal M eine Spannung $V_A$ ein, die der zu messenden Kapazität $C_M$ proportional ist:

$$V_A = V_R \frac{C_M}{C_R}$$

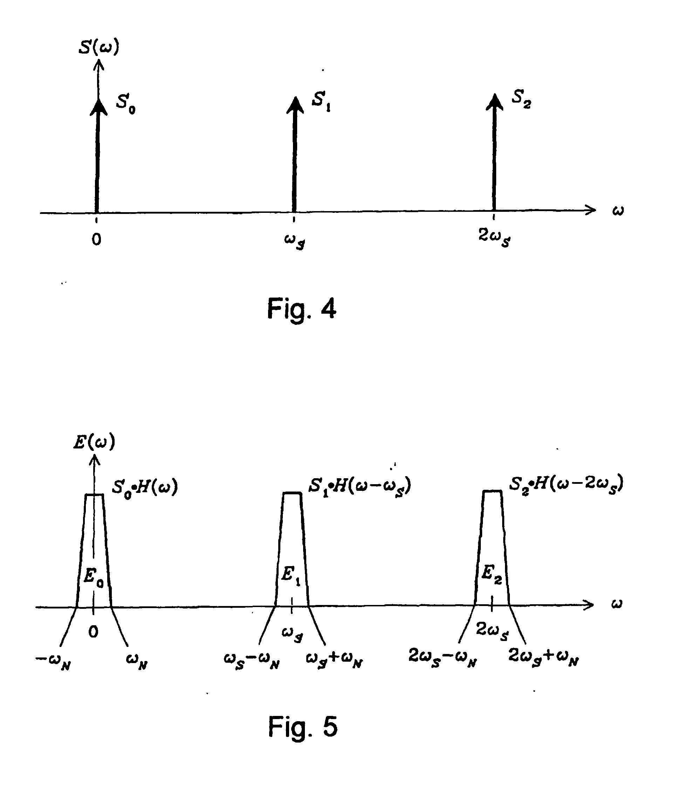

Die Auswertevorrichtung 14 in Fig. 1 und Fig. 2 arbeitet nach dem Abtastprinzip. Das Taktsignal S bestimmt dabei den zeitlichen Abstand $T_S$ zwischen zwei Auswertungen. Bei den üblichen taktgesteuerten Reaktanzmeßanordnungen ist die Frequenz $f_S$ des Taktsignals und demzufolge auch der zeitliche Abstand $T_S$ konstant. Für diesen Fall ist das Leistungsdichtespektrum $S(\omega)$ der entsprechenden Abtastfunktion in Fig. 4 dargestellt. Es berechnet sich durch:

$$S(\omega) = \sum_{i=-\infty}^{\infty} S_i \cdot \delta(\omega - i \cdot \omega_S)$$

mit:

$S(\omega)$        $\cong$ Leistungsdichtespektrum einer üblichen Abtastfunktion

$\omega_S = \frac{2 \cdot \pi}{T_S}$        $\cong$ Abtastfrequenz

$S_i$        $\cong$ Gewichtung entsprechend Apertur und Frequenzgang der Auswerteschaltung

$\delta(\omega)$        $\cong$ Dirac-Funktion

Entsprechend dem Nyquist-Abtasttheorem muß die Wiederholfrequenz $\omega_S$ der Auswertung mindestens doppelt so hoch sein wie die Bandbreite $\omega_N$ der zu messenden Größe. Das Verhältnis:

$$r = \frac{\omega_S}{2 \cdot \omega_N}$$

bezeichnet man als Oversampling-Rate. Bei einer Verletzung des Nyquist-Abtasttheorems (also bei r < 1) kommt es zu Aliasing-Fehlern.

In den meisten Anwendungen verlaufen die zeitlichen Änderungen der zu messenden Reaktanz verhältnismäßig langsam, und die Bandbreite $\omega_N$ des Nutzsignals kann meist gut abgeschätzt werden. Eine hohe Oversampling-Rate (Größenordnung $10^3$) ist deshalb möglich und wird zur Verbesserung der Meßgenauigkeit auch oft angewendet.

Auf die zu messende Reaktanz werden aber durch äußere Einflüsse auch störende Wechselsignale eingekoppelt. Die Frequenzen dieser Störungen können in Bereichen liegen, die zu einer Verletzung des Nyquist-Abtasttheorems führen. Durch Aliasing wird aus der Frequenz $\omega_p$ des ursprünglichen Störsignals ein abgetastetes Störsignal mit den Frequenzen $\omega_{Pa}$ :

$$\omega_{Pa} = \omega_P - i \cdot \omega_S$$

mit : i =- ∞, ..., -1, 0, 1, ..., ∞

Fig. 5 zeigt, in welchen Frequenzbereichen es zu einer Abbildung des Störsignals und damit zu einer Verfälschung der Reaktanzmessung kommen kann. Wie man sieht, ergeben sich in der näheren Umgebung von ganzzahligen Vielfachen der Abtastfrequenz $\omega_S$ Bereiche mit hoher Störempfindlichkeit.

Die Auswerteschaltung und die nachfolgende Signalverarbeitung filtern mit ihrer Übertragungsfunktion $H(\omega)$ den interessierenden Frequenzbereich (Basisband) heraus. Wegen der hohen Oversampling-Rate ist der Durchlaßbereich des Basisbandes im Vergleich zu $\omega_S$ sehr schmal. Durch Aliasing werden aber auf diesen Durchlaßbereich mehrere Frequenzbereiche des Eingangssignals der Auswerteschaltung abgebildet. Die Auswerteschaltung wird deshalb für mehrere Frequenzbereiche empfindlich:

$$E(\omega) = H(\omega) \cdot S(\omega)$$

$$E(\omega) = \sum_{i=-\infty}^{\infty} S_i \cdot H(\omega - i \cdot \omega_S)$$

mit:

$E(\omega)$ $\cong$ Empfindlichkeit der Auswerteschaltung
$H(\omega)$ $\cong$ Übertragungsfunktion des Basisbandes
$A*B$ $\cong$ Faltung von A und B

Störungen in der Nähe von ganzzahligen Vielfachen der Abtastfrequenz werden nur durch die Gewichtungs-faktoren $S_i$ bedämpft. Die Flächen $E_i$ der empfindlichen Bereiche berechnen sich durch:

$$E_i = \int_{i \cdot \omega_S - \omega_N}^{i \cdot \omega_S + \omega_N} E(\omega) \cdot d\omega = S_i \cdot \int_{-\omega_N}^{\omega_N} H(\omega) \cdot d\omega$$

Bei den in den Figuren 1 und 2 dargestellten Anordnungen wird der durch Aliasing hervorgerufene Einfluß schmalbandiger Störeinkopplungen dadurch verringert, daß das vom Taktsignalgenerator 16 erzeugte Taktsignal S für die Generatorvorrichtung 12 und für die Auswertevorrichtung 14 durch eine Steuervorrichtung 28 moduliert wird. Die Reaktanz 10 bzw. 20 wird also mit einer in vorgegebenen Grenzen von $\omega_S - \Delta\omega_S$ bis $\omega_S + \Delta\omega_S$ veränderlichen Abtast-frequenz gemessen. Die Zeit $T_S$ zwischen zwei Abtastungen ist dann mindestens $T_{S1}$ und höchstens $T_{S2}$ mit:

$$T_{S1} \leq T_S \leq T_{S2}$$

und

$$T_{S1} \leq T_{S2}$$

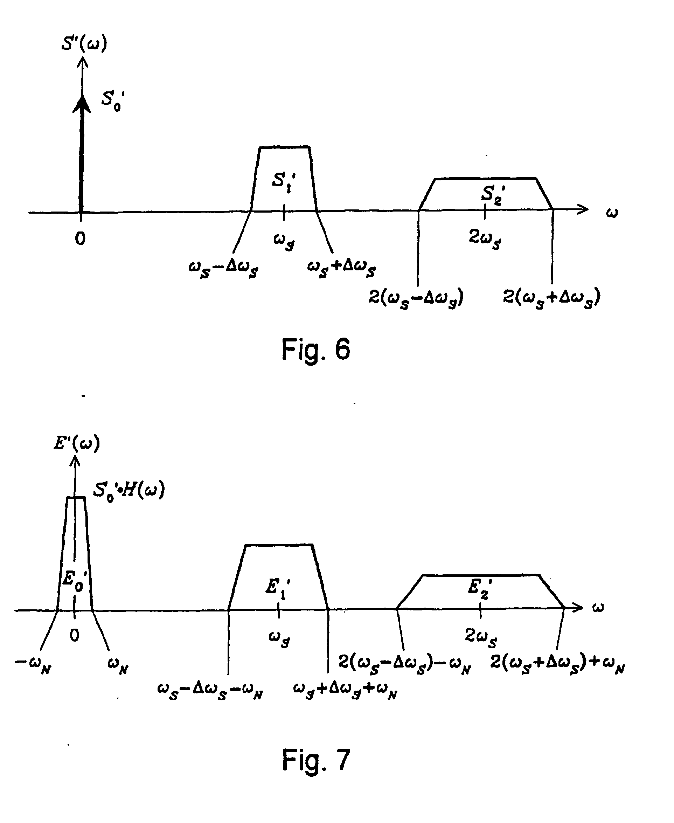

Zur Vereinfachung der weiteren Erklärungen sei angenommen, daß die Zeit $T_S$ nur langsam zwischen $T_{S1}$ und $T_{S2}$ verändert wird. Damit ergibt sich näherungsweise das in Fig. 6 dargestellte Leistungsdichtespektrum der Abtast-funktion. Es gelten:

$$\omega_S = \pi \cdot \frac{T_{S1} + T_{S2}}{T_{S1} \cdot T_{S2}}$$

$$\Delta\omega_S = \pi \cdot \frac{T_{S1} - T_{S2}}{T_{S1} \cdot T_{S2}}$$

Da bei der Modulation die Leistung der Abtastfunktion unverändert bleibt, gilt für die Flächeninhalte $S_i'$:

$$S_i' = \int_{i \cdot (\omega_S - \Delta\omega_S)}^{i \cdot (\omega_S + \Delta\omega_S)} S'(\omega) \cdot d\omega = S_i$$

mit : $i = -\infty, ..., -1, 0, 1, ..., \infty$
Durch Faltung mit der Übertragungsfunktion $H(\omega)$ erhält man die Empfindlichkeit $E'(\omega)$ der Meßanordnung, die in Fig. 7 dargestellt ist:

$$E'(\omega) = H(\omega)^*S'(\omega)$$

$$E'(\omega) = \int_{-\infty}^{\infty} H(\Omega) \cdot S'(\omega - \Omega) \cdot d\Omega$$

mit:

$E'(\omega)$ $\cong$ Empfindlichkeit der Auswerteschaltung mit moduliertem Abtasttakt
$S'(\omega)$ $\cong$ Leistungsdichtespektrum der modulierten Abtastfolge
$H(\omega)$ $\cong$ Übertragungsfunktion der folgenden Signalverarbeitung
$A^*B$ $\cong$ Faltung von A und B

Für die Flächen $E_i'$ der empfindlichen Meßbereiche gilt:

$$E_i' = \int_{i \cdot (\omega_S - \Delta\omega_S) - \omega_N}^{i \cdot (\omega_S + \Delta\omega_S) + \omega_N} E'(\omega) \cdot d\omega = E_i$$

und damit:

$$\int_{i \cdot (\omega_S - \Delta\omega_S) - \omega_N}^{i \cdot (\omega_S + \Delta\omega_S) + \omega_N} E'(\omega) \cdot d\omega = \int_{i \cdot \omega_S - \omega_N}^{i \cdot \omega_S + \omega_N} E(\omega) \cdot d\omega$$

Im Vergleich zu der mit konstanter Abtastfrequenz arbeitenden üblichen Meßanordnung ist die Empfindlichkeit $E'(\omega)$ in der Nähe von Vielfachen der Abtastfrequenz geringer und auf einen größeren Frequenzbereich aufgeweitet. Eine Störung, die sich nicht über die gesamte Bandbreite eines empfindlichen Bereichs ausdehnt, hat damit auf die Meßanordnung einen geringeren Einfluß als bei Anwendung einer konstanten Abtastfrequenz.

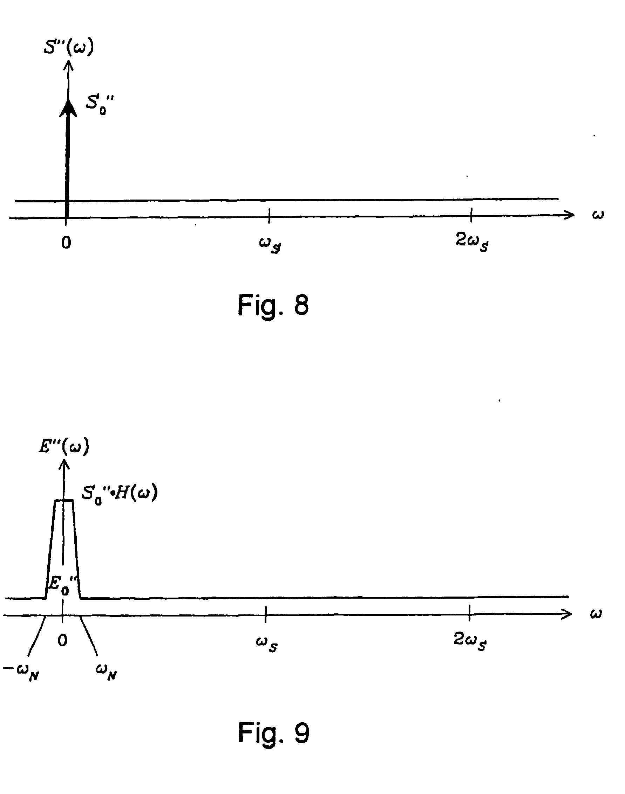

Bei der vorstehenden Beschreibung wurde zur Vereinfachung eine langsame Änderung der Abtastfrequenz angenommen. Das beschriebene Prinzip funktioniert jedoch bei jeder Art von Frequenz- und Phasenmodulation des Abtasttaktes. Die gewünschte Wirkung wird immer dann erreicht, wenn außer dem Gleichanteil alle spektralen Anteile der Abtastfunktion möglichst gleichmäßig auf weite Frequenzbereiche verteilt werden. Fig. 8 zeigt den Idealfall eines gleichmäß verteilten Leistung sdi chtespektrums $S''(\omega)$. Die daraus resultierende Empfindlichkeit $E''(\omega)$ ist in Fig. 9 dargestellt.

Für die Generatorvorrichtung 12 und die Auswertevorrichtung 14 sind außer den Schaltungen in SC-Technik, von denen eine als Beispiel in Fig. 2 dargestellt ist, eine Vielzahl von anderen Realisierungsmöglichkeiten bekannt. Schaltungen in SC-Technik haben den Vorteil, daß sie ein analoges Ausgangssignal liefern können, das unabhängig von der Variation des Taktes ist. Dies ist bei der in Fig. 2 dargestellten Schaltung der Fall.

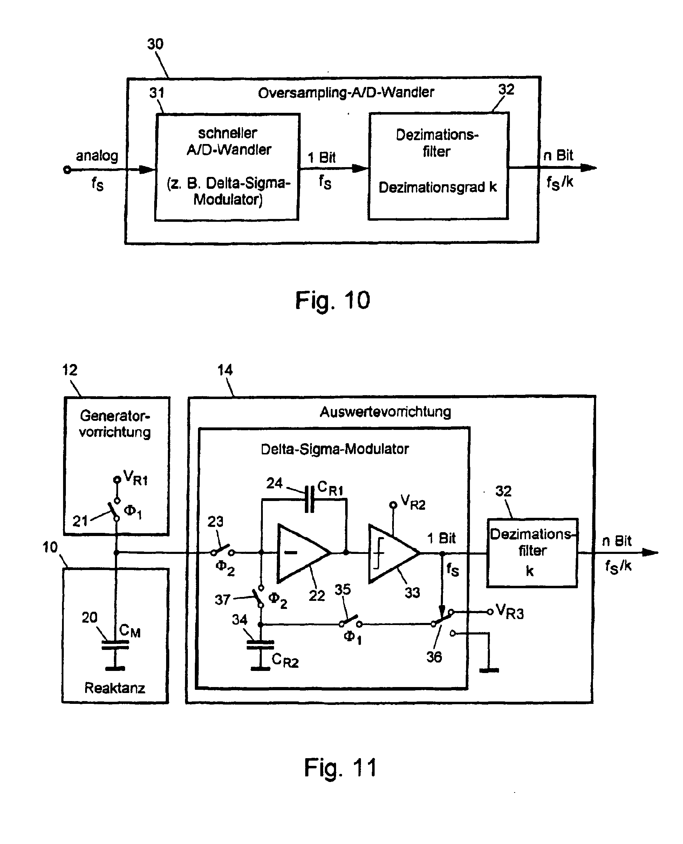

Benötigt man das Ausgangssignal der Auswertevorrichtung 14 in digitalisierter Form, dann wird die Auswertevorrichtung vorzugsweise um einen Oversampling-A/D-Wandler erweitert. Das Prinzip eines solchen Oversampling-A/D-Wandlers 30 ist in Fig. 10 dargestellt. Er enthält einen schnellen, aber ungenauen A/D-Wandler 31 und ein Dezimationsfilter 32 mit dem Dezimationsgrad k. Der A/D-Wandler 31, der beispielsweise durch einen Delta-Sigma-Modulator gebildet ist, empfängt am Eingang die analogen Abtastwerte im Abtasttakt fs und liefert am Ausgang digitale Signale mit der Auflösung 1 Bit im Abtasttakt $f_S$. Am Ausgang des Dezimationsfilters 32 erscheinen digitale Signale mit der Auflösung n Bit (n $\geq$ 1) im Takt $f_S$/k. Es ist auch möglich, für den A/D-Wandler 31 einen Delta-Sigma-Modulator höherer Ordnung zu verwenden, der digitale Signale mit einer Auflösung von m Bit (m > 1) im Abtasttakt $f_S$ liefert, wobei dann am Ausgang der Dezimationsfilters 32 die Auflösung n > m erhalten wird.

Fig. 11 zeigt, wie der Oversampling-A/D-Wandler -Wandler von Fig. 10 bei der in SC-Technik ausgebildeten Abtastvorrichtung 14 von Fig. realisiert werden kann. Die Schaltungsbestandteile, die denjenigen von Fig. 2 entsprechen, sind mit den gleichen Bezugzeichen wie dort bezeichnet. Der Taktsignalgenerator 16 und die Steuervorrichtung 28 sind zur Vereinfachung in Fig. 11 nicht dargestellt. Zur Bildung des Delta-Sigma-Modulators 31 ist dem Verstärker 22 ein Komparator 33 nachgeschaltet und ein zweiter Referenzkondensator 34 mit der Kapazität $C_{R2}$ vorgesehen, dessen eine Klemme an Masse liegt und dessen andere Klemme durch einen Schalter 35 mit einem vom Ausgangssignal des Komparators 33 gesteuerten Umschalter 36 und durch einen Schalter 37 mit dem Eingang des Verstärkers 22 verbunden werden kann. Der Schalter 35 wird synchron mit dem Schalter 21 in jeder Phase $\Phi_1$ des Taktsignals S geschlossen und in jeder Phase $\Phi_2$ des Taktsignals S geöffnet. Der Schalter 37 wird synchron mit dem Schalter 23 in jeder Phase $\Phi_2$ des Taktsignals S geschlossen und in jeder Phase $\Phi_1$ des Taktsignals S geöffnet. Dagegen entfällt der Schalter 25, der in Fig. 2 dem ersten Referenzkondensator 24 parallelgeschaltet ist, dessen Kapazität in Fig. 11 mit $C_{R1}$ bezeichnet ist. Die dem kapazitiven Sensor 20 über den Schalter 21 zugeführte Referenzspannung ist in Fig. 11 mit $V_{R1}$ bezeichnet. Der Komparator 33 empfängt eine zweite Referenzspannung $V_{R2}$ und erzeugt durch Vergleich des Ausgangssignals des Verstärkers 22 mit der zweiten Referenzspannung $V_{R2}$ ein digitales Ausgangssignal mit der Auflösung 1 Bit im Abtasttakt $f_S$. Dieses digitale Ausgangssignal steuert den Umschalter 36 so, daß über den Schalter 35, wenn dieser in der Phase $\Phi_1$ geschlossen ist, an den Referenzkondensator 34 eine dritte Referenzspannung $V_{R3}$ angelegt wird, wenn das digitale Ausgangssignal den Signalwert "1" hat, und an den Referenzkondensator 34 Massepotential angelegt wird, wenn das digitale Ausgangssignal den Signalwert "0" hat. Ferner wird das digitale Ausgangssignal des Komparators 33 dem an den Ausgang des Delta-Sigma-Modulators 31 angeschlossenen Dezimationsfilter 32 mit dem Dezimationsgrad k zugeführt. Das Dezimationsfilter 32 gibt am Ausgang digitale Signale mit der Auflösung n Bit im Takt $f_S/k$ ab. Dabei wird der Abtasttakt $f_S$ in der zuvor geschilderten Weise variiert.

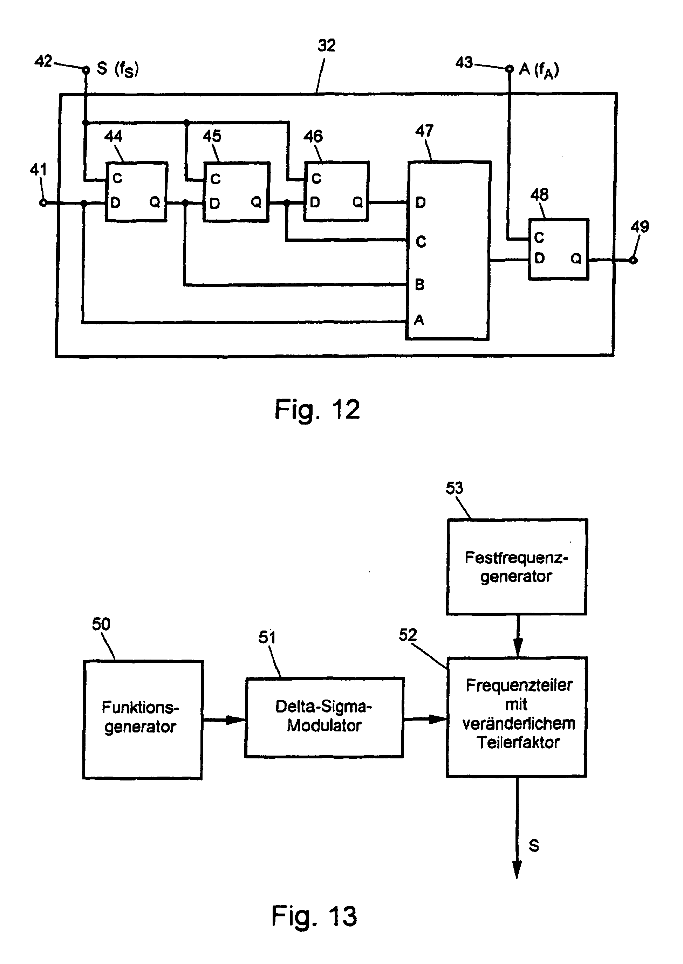

Obwohl der Oversampling-AD-Wandler 30 mit dem variablen Takt $f_S$ betrieben wird, kann erreicht werden, daß er am Ausgang seines Dezimationsfilters 32 einen Datenstrom mit konstanter Abtastrate liefert. Dazu werden die Änderungen des Taktes $f_S$ beispielsweise durch eine entsprechende Änderung des Dezimationsgrades k ausgeglichen. Fig. 12 zeigt schematisch eine Ausbildung des Dezimationsfilters 32, die diese Wirkung ergibt.

Das Dezimationsfilter 32 von Fig. 12 empfängt an einem Signaleingang 41 das digitale Signal mit der Auflösung 1 Bit in dem veränderlichen Abtasttakt $f_S$, an einem ersten Takteingang 42 das Taktsignal S mit der veränderlichen Taktfrequenz $f_S$ und an einem zweiten Takteingang 43 ein Taktsignal A mit dem gewünschten konstanten Ausgangstakt $f_A$. Es enthält drei in Kaskade geschaltete Register 44, 45, 46, deren Takteingänge C mit dem ersten Takteingang 42 verbunden sind. Der Signaleingang D des Registers 44 ist mit dem Signaleingang 41 des Dezimationsfilters 32 verbunden, der Signaleingang D des Registers 45 ist mit dem Ausgang Q des Registers 44 verbunden, und der Signaleingang D des Registers 46 ist mit dem Ausgang Q des Registers 45 verbunden. Ein Addierer 47 hat einen Eingang A, der direkt mit dem Signaleingang 41 des Dezimationsfilters 32 verbunden ist, und drei weitere Eingänge B, C, D, die jeweils mit dem Ausgang Q eines der Register 44, 45, 46 verbunden sind. Somit werden die dem Signaleingang 41 zugeführten digitalen Signale in dem veränderlichen Abtasttakt $f_S$ der Reihe nach durch die Register 44, 45, 46 verschoben, und der Addierer 47 empfängt an seinen Eingängen zugleich mit dem gerade am Eingang 41 anliegenden digitalen Signal auch die drei vorhergehenden digitalen Signale, die in den Registern 44, 45, 46 gespeichert sind. Der Addierer 47 bildet die Summe dieser vier digitalen Signale, die er an seinem Ausgang abgibt. An den Ausgang des Addierers 47 ist der Signaleingang D eines weiteren Registers 48 angeschlossen, dessen Takteingang C mit dem Takteingang 43 des Dezimationsfilters 32 verbunden ist. Somit übernimmt das Register 48 die vom Addierer 47 abgegebenen digitalen Summensignale in dem gewünschten konstanten Ausgangstakt $f_A$, und er gibt diese digitalen Summensignale mit erhöhter Auflösung und im konstanten Takt $f_A$ am Ausgang 49 des Dezimationsfilters 32 ab.

Ein Datenstrom mit konstanter Abtastrate kann auch bei Verwendung eines Dezimationsfilters mit festem Dezimationsgrad k erreicht werden. Dies ist dann möglich, wenn die k unterschiedlich langen Takte der zur Dezimation herangezogenen Abtastwerte in ihrer Summe immer eine konstante Zeit ergeben. Diese Bedingung ist bei einer periodischen Modulation des Taktes mindestens bei ganzzahligen Vielfachen der Wiederholdauer erfüllt.

Die Modulation des Abtasttaktes kann analog oder digital erfolgen. Die Steuervorrichtung 28 kann mit dem Taktgenerator 16 auch in einer Baugruppe kombiniert sein. Eine solche kombinierte Baugruppe ist beispielsweise in der EP 0 715 408 A1 beschrieben. Für die Erzeugung eines stochastischen Taktsignals eignen sich zum Beispiel Oszillatorschaltungen mit hohem Frequenz-Jitter. Eine Schaltung zur Erzeugung eines Erfassungstaktes mit Phasenzittern unter Verwendung einer Phasenverriegelungsschleife ist in der DE 196 37 942 A1 beschrieben.

Beispiele für eine determinierte Modulation sind eine sägezahn- oder dreieckförmige Veränderung der Taktfrequenz.

Wenn die Modulation des Abtasttaktes auf digitalem Wege erfolgt, kann die Zeit $T_S$ zwischen zwei Abtastungen jeweils nur einen von N diskreten Werten annehmen. Durch geeignete Aneinanderreihung solcher diskreter Abstände lassen sich im Frequenzsspektrum auch Zwischenfrequenzen bilden. Für die Auswahl der Abstände kann zum Beispiel ein Delta-Sigma-Modulator verwendet werden. Fig. 13 zeigt eine mögliche Ausführungsform einer hierfür geeigneten kombinierten Steuervorrichtung und Takterzeugung. Sie enthält einen Funktionsgenerator 50, der ein Funktionssignal erzeugt, das der gewünschten Modulationsfunktion entspricht. Der Ausgang des Funktionsgenerators 50 ist mit dem Eingang eines Delta-Sigma-Modulators 51 verbunden. Der Delta-Sigma-Modulator 51 steuert den Teilerfaktor eines Frequenzteilers 52 mit umschaltbarem Teilerfaktor, der an seinem Signaleingang das Ausgangssignal eines Festfrequenzgenerators 53 empfängt. Das Ausgangssignal des Frequenzteilers 52 bildet das Taktsignal S, dessen Frequenz $f_S$ durch den variablen Teilerfaktor des Frequenzteilers 52 bestimmt ist, der durch den Delta-Sigma-Modulator 51 entsprechend dem Funktionssignal des Funktionsgenerators 50 eingestellt wird.

**Patentansprüche**

1. Verfahren zur zeitdiskreten Messung einer Reaktanz ($C_M$), bei welchem Verfahren die Reaktanz ($C_M$) durch eine taktgesteuerte Generatorvorrichtung (12) mit einer elektrischen Spannung, einem elektrischen Strom oder einer elektrischen Ladung angeregt wird und
eine taktgesteuerte Auswertevorrichtung (14) ein Ausgangssignal als Funktion der zu messenden Reaktanz ($C_M$) aus zeitdiskreten Abtastwerten der elektrischen Spannung, des elektrischen Stroms oder der elektrischen Ladung erzeugt,
wobei die Generatorvorrichtung (12) und die Auswertevorrichtung (14) mittels eines Taktsignals (S) im gleichen Takt gesteuert werden,
wobei das Taktsignal (S) ein Rechtecksignal ist, das abwechselnde Phasen $\Phi_1$ und $\Phi_2$ hat, und
wobei der die Generatorvorrichtung (12) und die Auswertevorrichtung (14) steuernde Takt in gleicher Weise durch eine Frequenz- oder Phasenmodulation variiert wird, wobei
die zu messende Reaktanz ein kapazitiver Sensor mit einer Kapazität ($C_M$) ist, die in jeder Phase $\Phi_1$ des Taktsignals (S) auf eine Referenzspannung ($V_R$) aufgeladen und in jeder Phase $\Phi_2$ Taktsignals (S) in eine Referenzkapazität ($C_R$) entladen wird, und wobei
die Referenzkapazität ($C_R$) lediglich in jeder Phase $\Phi_1$ des Taktsignals (S) entladen wird.

2. Verfahren nach Anspruch 1, **dadurch gekennzeichnet, daß** die Frequenz oder Phase des Taktes durch ein periodisches Signal moduliert wird.

3. Verfahren nach Anspruch 1, **dadurch gekennzeichnet, daß** die Frequenz oder Phase des Taktes durch einen Zufallsgenerator moduliert wird.

4. Verfahren nach einem der Ansprüche 1 bis 3, **dadurch gekennzeichnet, daß** die Frequenz oder Phase des Taktes nur in einer endlichen Anzahl von Werten geändert wird.

5. Verfahren nach Anspruch 4, **dadurch gekennzeichnet, daß** die modulierte Frequenz oder Phase des Taktes aus einem konstanten Grundtakt abgeleitet wird.

6. Vorrichtung zur Durchführung eines Verfahrens zur zeitdiskreten Messung einer Reaktanz ($C_M$), bei welchem die Reaktanz ($C_M$) durch eine taktgesteuerte Generatorvorrichtung (12) mit einer elektrischen Spannung, einem elektrischen Strom oder einer elektrischen Ladung angeregt wird und eine taktgesteuerte Auswertevorrichtung (14) ein Ausgangssignal als Funktion der zu messenden Reaktanz ($C_M$) aus zeitdiskreten Abtastwerten der elektrischen Spannung, des elektrischen Stroms oder der elektrischen Ladung erzeugt, wobei die Generatorvorrichtung (12) und die Auswertevorrichtung (14) mittels eines Taktsignals (S) Im gleichen Takt gesteuert werden, wobei das Taktsignal (S) ein Rechtecksignal ist, das abwechselnde Phasen $\Phi_1$ und $\Phi_2$ hat, und wobei der die Generatorvorrichtung (12) und die Auswertevorrichtung (14) steuernde Takt in gleicher Weise durch eine Frequenz- oder Phasenmodulation variiert wird, welche Vorrichtung umfasst: eine taktgesteuerte Generatorvorrichtung zur Anregung der zu messenden Reaktanz mit einer elektrischen Spannung, einem elektrischen Strom oder einer elektrischen Ladung, einer taktgesteuerten Auswerteschaltung zur Erzeugung eines Ausgangssignals als Funktion der zu messenden Reaktanz aus zeitdiskreten Abtastwerten der elektrischen Spannung, des elektrischen Stroms oder der elektrischen Ladung, eine Taktgenerator, der einen die Generatorvorrichtung und die Auswerteschaltung steuernden gemeinsamen Takt erzeugt, und eine Steuervorrtchtung zur Modulation der Frequenz oder der Phase des vom Taktgenerator erzeugten Taktes, wobei die Auswerteschaltung einen Oversampling-A/D-Wandler enthält der so ausgebildet ist, dass er trotz des variablen Eingangstaktes ein Ausgangssignal mit konstantem Ausgangstakt liefert.

7. Vorrichtung nach Anspruch 6, **dadurch gekennzeichnet, daß** die Generatorvorrichtung (12) und die Auswertevorrichtung (14) mit Schalter-Kondensator-Strukturen in SC-Technik ausgebildet sind.

8. Vorrichtung nach Anspruch 6, **dadurch gekennzeichnet, daß** der Oversampling-A/D-Wandler (30) ein Dezimationsfilter (32) enthält, dessen Dezimationsgrad variiert wird.

9. Vorrichtung nach Anspruch 6, **dadurch gekennzeichnet, daß** der Oversampling-A/D-Wandler (30) ein Dezimationsfilter (32) mit konstantem Dezimationsgrad enthält und daß der Takt so variiert wird, daß die Summe der variablen Abstände zwischen den zur Dezimation herangezogenen Abtastwerten einen konstanten Wert ergibt.

10. Vorrichtung nach Anspruch 8 oder 9, **dadurch gekennzeichnet, daß** der Oversampling-A/D-Wandler (30) einen Delta-Sigma-Modulator (31) enthält, dem das Dezimationsfilter (32) nachgeschaltet ist.

**11.** Vorrichtung nach einem der Ansprüche 6 bis 10, **dadurch gekennzeichnet, daß** die Steuervorrichtung (28) einen Funktionsgenerator enthält, der die Modulation des Abtasttaktes bestimmt.

**12.** Vorrichtung nach Anspruch 11, **dadurch gekennzeichnet, daß** der Taktgenerator (16) einen Festfrequenzgenerator enthält, dem ein Frequenzteiler mit umschaltbarem Teilerfaktor nachgeschaltet ist, und daß der Funktionsgenerator den Teilerfaktor des Frequenzteilers steuert.

**13.** Vorrichtung nach Anspruch 12, **dadurch gekennzeichnet, daß** dem Funktionsgenerator ein Delta-Sigma-Modulator nachgeschaltet ist.

**Claims**

**1.** Method for the time- discrete measurement of a reactance ($C_M$), wherein in said process the reactance ($C_M$) is excited by a clock- controlled generator unit (12) with an electrical voltage, an electrical current or an electrical charge, and a clock- controlled evaluation unit (14) generates an output signal as the function of the reactance ($C_M$) under measurement from time- discrete sampling values of the electrical voltage, the electrical current, or the electrical charge,
wherein the generator unit (12) and the evaluation unit (14) are controlled in a synchronised fashion by a clock signal (S),
wherein the clock signal (S) is a rectangular signal that has alternating phases $\theta_1$ and $\theta_2$ and
wherein the clock that controls the generator unit (12) and the evaluation unit (14) is varied in the same way by a frequency or phase modulation,
wherein the reactance under measurement is a capacitance sensor with a capacitance ($C_M$) which is charged in each phase $\theta_1$ of the clock signal (S) in relation to a reference voltage ($V_R$) and discharged in every phase $\theta_2$ of the clock signal (S) to a reference capacitance ($C_R$), and
wherein the reference capacitance ($C_R$) is only discharged in every phase $\theta_1$ of the clock (S) .

**2.** Method as claimed in Claim 1, **characterised in that** the clock frequency or phase is modulated by a periodic signal.

**3.** Method as claimed in Claim 1, **characterised in that** the clock frequency or phase is modulated by a random generator.

**4.** Method as claimed in Claims 1 to 3, **characterised in that** the clock frequency or phase is modified only in a finite number of values.

**5.** Method as claimed in Claim 4, **characterised in that** the modulated clock frequency or phase is derived from a constant basic clock rate.

**6.** A unit designed to carry out a method for the time-discrete measurement of a reactance ($C_M$), wherein the reactance ($C_M$) is excited by a clock-controlled generator unit (12) with an electrical voltage, an electrical current or an electrical charge and a clock-controlled evaluation unit (14) generates an output signal as a function of the reactance ($C_M$) under measurement from time-discrete sampling values of the electrical voltage, the electrical current, or the electrical charge, wherein the generator unit (12) and the evaluation unit (14) are controlled in a synchronised fashion by a clock signal (S), wherein the clock signal (S) is a rectangular signal that has alternating phases $\theta_1$ and $\theta_2$, and wherein the clock that controls the generator unit (12) and the evaluation unit (14) is varied in the same way by a frequency or phase modulation, said unit comprising :

a clock-controlled generator unit to excite the reactance under measurement with an electrical voltage, an electrical current or an electrical charge, a clock-controlled evaluation circuit to generate an output signal as a function of the reactance under measurement from time-discrete sampling values of the electrical voltage, the electrical current or the electric charge, a clock generator that generates a common clock rate that controls the generator unit and the evaluation circuit, and a control unit to modulate the frequency or the phase of the clock rate generated by the clock generator, wherein the evaluation circuit contains an oversampling A/D converter that is configured in such a way that it delivers an output signal with a constant output clock rate despite the variable input clock rate.

7.  Unit as claimed in Claim 6, **characterized in that** the generator unit (12) and the evaluation unit (14) are designed with switched capacitor structures using SC technology.

8.  Unit as claimed in Claim 6, **characterized in that** the oversampling A/D convertor (30) contains a decimation filter (32) whose rate of decimation is varied.

9.  Unit as claimed in Claim 6, **characterized in that** the oversampling A/D convertor (30) contains a decimation filter (32) with a constant rate of decimation and **in that** the cycle rate is varied in such a way that the sum of the variable intervals between the sampling values used for decimation yields a constant value.

10.  Unit as claimed in Claim 8 or 9, **characterized in that** the oversampling A/D convertor (30) contains a delta-sigma modulator (31) downstream of which the decimation filter (32) is connected.

11.  Unit as claimed in one of the Claims 6 to 10, **characterized in that** the control unit (28) contains a function generator that determines the modulation of the sampling clock rate.

12.  Unit as claimed in Claim 11, **characterized in that** the clock generator (16) contains a fixed frequency generator, downstream of which a frequency scaler with an adjustable scaling factor is connected, and **in that** the function generator controls the scaler factor of the frequency scaler.

13.  Unit as claimed in Claim 12, **characterized in that** a delta-sigma modulator is connected downstream from the function generator.

**Revendications**

1.  Procédé destiné à la mesure par valeurs discrètes en temps d'une réactance ($C_M$), procédé pour lequel la réactance ($C_M$) est excitée par un dispositif générateur (12) commandé par horloge avec une tension électrique, un courant électrique ou une charge électrique, et pour lequel un dispositif d'exploitation (14) commandé par horloge génère un signal de sortie en tant que fonction de la réactance ($C_M$) à mesurer à partir de valeurs d'échantillonnage discrètes en temps de la tension électrique, du courant électrique ou de la charge électrique,
    pour lequel le dispositif générateur (12) et le dispositif d'exploitation (14) sont commandés de façon synchronisée au moyen d'un signal d'horloge (S),
    pour lequel le signal d'horloge (S) est un signal rectangulaire, qui présente des phases $\theta_1$ et $\theta_2$ alternantes, et
    pour lequel la commande synchronisée du dispositif générateur (12) et du dispositif d'exploitation (14) est variée de façon égale par une modulation de fréquence ou de phase,
    pour lequel la réactance à mesurer est un capteur capacitif avec une capacité ($C_M$), qui est chargé dans chaque phase $\theta_1$ du signal d'horloge (S) par rapport à une tension de référence ($V_R$), et déchargé dans chaque phase $\theta_2$ du signal d'horloge (S) dans une capacité de référence ($C_R$), et
    pour lequel la capacité de référence ($C_R$) est uniquement déchargée dans chaque phase $\theta_1$ du signal d'horloge (S).

2.  Procédé selon la revendication 1, **caractérisé en ce que** la fréquence ou la phase de l'horloge est modulée par un signal périodique.

3.  Procédé selon la revendication 1, **caractérisé en ce que** la fréquence ou la phase de l'horloge est modulée par un générateur aléatoire.

4.  Procédé selon la revendication 1 à 3, **caractérisé en ce que** la fréquence ou la phase de l'horloge n'est modifiée que selon un nombre fini de valeurs.

5.  Procédé selon la revendication 4, **caractérisé en ce que** la fréquence ou la phase de l'horloge est dérivée d'une horloge de base constante.

6.  Dispositif destiné à la réalisation d'un procédé destiné à la mesure par valeurs discrètes en temps d'une réactance ($C_M$), pour lequel la réactance ($C_M$) est excitée par un dispositif générateur (12) commandé par horloge, avec une tension électrique, un courant électrique ou une charge électrique, et pour lequel un dispositif d'exploitation (14) commandé par horloge génère un signal de sortie en tant que fonction de la réactance ($C_M$) à mesurer à partir de valeurs d'échantillonnage discrètes en temps de la tension électrique, du courant électrique ou de la charge électrique, pour lequel le dispositif générateur (12) et le dispositif d'exploitation (14) sont commandés de façon synchronisée au moyen d'un signal d'horloge (S), pour lequel le signal d'horloge (S) est un signal rectangulaire, qui présente des phases $\theta_1$ et $\theta_2$ alternantes, et pour lequel la commande synchronisée du dispositif générateur (12) et du dispositif d'exploitation (14) est variée de façon égale par une modulation de fréquence ou de phase, lequel dispositif comprend :

un dispositif générateur commandé par horloge, destiné à l'excitation de la réactance à mesurer avec une tension électrique, un courant électrique ou une charge électrique

un dispositif d'exploitation commandé par horloge, destiné à la génération d'un signal de sortie en tant que fonction de la réactance à mesurer à partir de valeurs d'échantillonnage discrètes en temps de la tension électrique, du courant électrique ou de la charge électrique

un générateur d'horloge, qui génère une horloge commandant de façon synchronisée le dispositif générateur et le circuit d'exploitation, et

un dispositif de commande destiné à la modulation de la fréquence ou de la phase de l'horloge générée par le générateur d'horloge, le circuit d'exploitation contenant un convertisseur N/A de suréchantillonnage, lequel est conçu de telle sorte à fournir un signal de sortie avec horloge de sortie constante malgré l'horloge d'entrée variable.

7. Procédé selon la revendication 6, **caractérisé en ce que** le dispositif générateur (12) et le dispositif d'exploitation (14) sont conçus avec des structures à capacités commutées en technique SC.

8. Procédé selon la revendication 6, **caractérisé en ce que** le convertisseur N/A de suréchantillonnage (30) contient un filtre de décimation (32), dont le taux de décimation est varié.

9. Procédé selon la revendication 6, **caractérisé en ce que** le convertisseur N/A de suréchantillonnage (30) contient un filtre de décimation constant et **en ce que** la cadence est variée de telle sorte que la somme des distances variables entre les valeurs d'échantillonnage utilisées pour la décimation donne une valeur constante.

10. Procédé selon la revendication 8 ou 9, **caractérisé en ce que** le convertisseur N/A de suréchantillonnage (30) contient un modulateur Delta-Sigma (31), auquel est couplé en aval le filtre de décimation (32).

11. Procédé selon la revendication 6 à 10, **caractérisé en ce que** le dispositif de commande (28) contient un générateur de fonctions, qui détermine la modulation de la cadence d'échantillonnage.

12. Procédé selon la revendication 11, **caractérisé en ce que** le générateur d'horloge (16) contient un générateur de fréquence fixe, auquel est couplé en aval un diviseur de fréquence avec facteur de division commutable, et **en ce que** le générateur de fonctions commande le facteur de division du diviseur de fréquence.

13. Procédé selon la revendication 12, **caractérisé en ce qu'**un modulateur Delta-Sigma est couplé en aval du générateur de fonctions.

**Fig. 1**

**Fig. 2**

**Fig. 3**

$S(\omega)$

$S_0$

$S_1$

$S_2$

0           $\omega_S$         $2\omega_S$

       $\omega$

## Fig. 4

$E(\omega)$

$S_0 \cdot H(\omega)$      $S_1 \cdot H(\omega - \omega_S)$      $S_2 \cdot H(\omega - 2\omega_S)$

$E_0$          $E_1$          $E_2$

0        $\omega_S$        $2\omega_S$     $\omega$

$-\omega_N$    $\omega_N$     $\omega_S - \omega_N$    $\omega_S + \omega_N$    $2\omega_S - \omega_N$    $2\omega_S + \omega_N$

## Fig. 5

Fig. 6

Fig. 7

Fig. 8

Fig. 9

Fig. 10

Fig. 11

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3544187 A1
- EP 0715408 A1
- DE 19637942 A1
- DE 197021899 A1

**In der Beschreibung aufgeführte Nicht-Patentliteratur**

- **HIROKI MATSUMOTO ; KENZO WATANABE.** A Switched-Capacitor Digital Capacitance Meter. *IEEE Transactions on Instrumentation and Measurement,* Dezember 1986, vol. IM-35 (4), 355-359